# EUROPÄISCHE PATENTSCHRIFT

(11) **EP 1 577 211 B1**
(45) Veröffentlichungstag und Bekanntmachung des Hinweises auf die Patenterteilung: **04.01.2017**
(21) Anmeldenummer: 05002636.8
(22) Anmeldetag: 09.02.2005
(51) Int. Cl.: B64C 1/20, B64D 9/00, B64D 45/00, H05K 7/14

(54) **Vorrichtung zur Befestigung einer Einheit an Befestigungseinrichtungen eines Fahrzeugs**
Aircraft unit fastening arrangement
Dispositif de fixation d'une unité à un aéronef

(30) Priorität: 20.03.2004 DE 102004013878
(43) Veröffentlichungstag der Anmeldung: 21.09.2005
(73) Patentinhaber: Leica Geosystems AG, 9435 Heerbrugg (CH)
(72) Erfinder: Glöckler, Gerd, 89197 Weidenstetten (DE)
(74) Vertreter: Lorenz, Werner

(56) Entgegenhaltungen:
- EP-A2- 1 026 027
- JP-A- 5 096 983
- US-A- 3 783 197
- US-B1- 6 601 900

## Beschreibung

Die Erfindung betrifft eine Vorrichtung zur Befestigung einer Einheit an Befestigungseinrichtungen eines Fahrzeugs, insbesondere eines Luftfahrzeuges, mit Befestigungsgliedern, welche zur Verbindung mit den Befestigungseinrichtungen vorgesehen sind.

Aus dem allgemeinen Stand der Technik ist es bekannt, Einheiten, die an Befestigungseinrichtungen eines Fahrzeugs angebracht werden sollen, mittels Befestigungsgliedern zu verschrauben oder in ähnlicher Weise zu verbinden. Die Fahrzeuge weisen hierfür im allgemeinen Befestigungseinrichtungen auf, die in mehr oder weniger regelmäßigen Abständen zueinander angeordnet sind. Die Befestigungseinrichtungen können dabei beispielsweise als Schienen ausgebildet und im Boden eines Innenraums des Fahrzeugs angeordnet sein.

In Luftfahrzeugen sind die Befestigungseinrichtungen in üblicher Weise als Befestigungsschienen bzw. als Sitzschienen ausgebildet. Dabei sind eine Vielzahl von Sitzschienen - im wesentlichen parallel zueinander verlaufend - vorgesehen. Dokument US 6, 601, 900 B1 zeigt eine solche Befestigungseinrichtung. Es stellt den nächstliegenden Stand der Technik dar und offenbart den Oberbegriff des ersten Anspruchs. Zur Befestigung von Flugzeugsitzen werden Befestigungsglieder verwendet, die als Sitzschienenfittings ausgebildet sind. Diese Sitzschienenfittings sind speziell zur Verbindung mit den Sitzschienen ausgebildet und werden an der vorgesehenen Stelle in der Sitzschiene arretiert und anschließend mit dem Flugzeugsitz verschraubt. In üblicher Weise wird der Sitz zur stabilen Anordnung dabei mit zwei parallel zueinander verlaufenden Sitzschienen verschraubt. Die Sitze sind dabei hinsichtlich ihrer Befestigungspunkte auf den Abstand zwischen den Sitzschienen des Flugzeugs, in dem diese befestigt werden sollen, angepasst. Da der Abstand zwischen den Sitzschienen abhängig vom Flugzeugtyp und individuellen Gestaltungswünschen ist, können an den Sitzschienen bzw. zwischen zwei Sitzschienen keine Einheiten befestigt werden, die nicht speziell auf die Sitzschienen des jeweiligen Flugzeugs bzw. dessen Abstand zueinander angepasst sind. Daher müssen Einheiten, die nicht dem vorgegebenen Raster zwischen den Sitzschienen entsprechen, auf andere, oft unzureichende Weise in dem Luftfahrzeug befestigt werden.

Insbesondere bei der Anordnung von sogenannten Festplattenspeichern bzw. Flugdatenspeichern in einem Luftfahrzeug oder einem anderen Fahrzeug sind an die Befestigung besonders hohe Ansprüche zu stellen. Da auf die Festplattenspeicher bzw. Flugdatenspeicher während des Fluges Daten abgelegt werden, ist eine stabile und zuverlässige Verbindung dieser Einheiten mit dem Flugzeug unerlässlich. Dies gilt insbesondere, wenn auf den Flugdatenspeicher während eines Bildfluges eines Flugzeuges Daten von einer digitalen Kamera abgelegt werden. Bei diesen Daten kann es sich z.B. um Bilddaten, ergänzende Daten zu den Bildern, wie z.B. Missionsdaten, Systeminformationen oder Informationen für das Post Processing handeln. Der Flugdatenspeicher ist im allgemeinen als Massenspeicher zur "digital mapping camera" ausgelegt.

Elektrisch und mechanisch ist jeder Flugdatenspeicher eine eigenständige Einheit, die über einen Bilddatenanschluss mit der digitalen Kamera verbunden ist.

Nach der mechanischen Verbindung des Flugdatenspeichers mit dem Flugzeug müssen in einem weiteren Arbeitsgang die notwendigen Kabel an dem Flugdatenspeicher angeschlossen werden. Nach der Landung wird der Flugdatenspeicher entnommen und die Bilddaten auf einen erdgebundenen Massenspeicher kopiert.

Von Nachteil bei den bekannten Flugdatenspeichern ist, dass sich diese nur unzureichend mechanisch mit dem Luftfahrzeug verbinden lassen. Darüber hinaus ist der Flugdatenspeicher aufgrund der während des Flugbetriebs auftretenden Verwindungen und Verspannungen entsprechenden Belastungen ausgesetzt, die sich negativ auf die Funktionsfähigkeit auswirken. Ein weiterer Nachteil besteht darin, dass Flugdatenspeicher in unterschiedlichen Flugzeugtypen eingesetzt werden, so dass jeweils individuell nach einer geeigneten Befestigungslösung gesucht werden muss. Da die Flugzeugtypen jeweils unterschiedliche Sitzschienenabstände aufweisen, ist eine Anordnung des Flugdatenspeichers an Sitzschienen nicht möglich.

Von Nachteil ist außerdem, dass das Verbinden des Flugdatenspeichers mit den weiterführenden Kabeln aufgrund der beengten Platzverhältnisse im Flugzeug oftmals sehr diffizil ist. Ein falscher Anschluss von Kabeln kann dabei zu einer Fehlfunktion führen. Besonders bedeutsam ist dabei auch, dass die Steckverbindungen zuverlässig, insbesondere vibrations- und stoßsicher sind, da ansonsten aufgrund der Flugbewegungen des Flugzeugs die Gefahr eines versehentlichen Lösens der Verbindungen zu befürchten ist.

Der vorliegenden Erfindung liegt die Aufgabe zugrunde, eine Vorrichtung zur Befestigung einer Einheit an Befestigungseinrichtungen eines Fahrzeugs, insbesondere eines Luftfahrzeuges, zu schaffen, die die vorgenannten Nachteile des Standes der Technik löst, insbesondere eine zuverlässige und stabile Befestigung der Einheit, unabhängig vom Typ des Fahrzeugs sowie der Anordnung der Befestigungseinrichtungen, ermöglicht.

Diese Aufgabe wird erfindungsgemäß durch den kennzeichnenden Teil von Anspruch 1 gelöst.

Dadurch, dass die zu befestigende Einheit mittels wenigstens einem Befestigungsadapter mit der Befestigungseinrichtung verbindbar ist, lässt sich die Einheit durch die Wahl eines entsprechend geeigneten Befestigungsadapters bzw. dessen Ausgestaltung an beliebig angeordneten Befestigungseinrichtungen befestigen. In einer Ausgestaltung der Befestigungseinrichtungen als Befestigungsschienen bzw. Sitzschienen eines Fahrzeugs, beispielsweise eines Luftfahrzeugs, ist es möglich, die zu befestigende Einheit durch die Wahl eines entsprechenden Befestigungsadapters an den Schienenabstand des vorgesehenen Luftfahrzeugs anzupassen. Die zu befestigende Einheit kann daher für alle Fahrzeugtypen identisch hergestellt werden. Angepasst an die verschiedenen Befestigungseinrichtungen wird dann ein geeigneter Befestigungsadapter eingesetzt. Vorgesehen sein kann dabei auch, dass der Befestigungsadapter eine Verstellmöglichkeit aufweist und somit an unterschiedliche Sitzschienenabstände anpassbar ist.

Erfindungsgemäß wird die zu befestigende Einheit an Sitzschienen im Flugzeug befestigt. Daraus resultiert eine besonders stabile und zuverlässige Verbindung. Bislang war eine derartige Anordnung nicht möglich bzw. hätte zur Folge gehabt, dass die zu befestigende Einheit speziell angepasst an den Abstand zwischen den Sitzschienen hergestellt werden muss. Dies ist jedoch konstruktiv aufwändig und verursacht hohe Zusatzkosten. Im Flugzeug stellen die Sitzschienen eine der sichersten und stabilsten Befestigungsmöglichkeit dar. Im allgemeinen sind die Sitzschienen auch nahezu überall im Flugzeug angeordnet, so dass die zu befestigende Einheit an einer beliebigen Position im Flugzeug angebracht bzw. montiert werden kann.

Von Vorteil ist es, wenn die zu befestigende Einheit als Adapter für einen Flugdatenspeicher ausgebildet ist.

Insbesondere bei Flugdatenspeichern ist eine stabile und sichere Verbindung mit dem Flugzeug besonders bedeutsam, da während dem Flugbetrieb Daten auf dem Flugdatenspeicher abgelegt werden. Bislang wurden die Flugdatenspeicher auf irgendeine Weise mit einer Wand des Flugzeugs oder dem Boden verschraubt bzw. dort angebunden. Nunmehr ist es in einfacher Weise möglich, einen Adapter zur Aufnahme des Flugdatenspeichers an einer beliebigen Stelle im Flugzeug an den Sitzschienen stabil und sicher zu montieren. Zum Betrieb des Flugdatenspeichers wird dieser in einfacher Weise in den Adapter eingesetzt und dort fixiert. Der Adapter kann dabei derart ausgebildet sein, dass beim Einschieben des Flugdatenspeichers in den Adapter gleichzeitig eine Verbindung mit den weiterführenden Kabeln, beispielsweise zu einer digitalen Kamera, geschlossen wird.

Von Vorteil ist es, wenn zur Befestigung der Einheit zwei Befestigungsadapter vorgesehen sind. '

Durch den Einsatz von zwei Befestigungsadaptern kann die zu befestigende Einheit in einfacher Weise an zwei Sitzschienen angeordnet werden.

Von Vorteil ist es, wenn wenigstens ein Befestigungsadapter eine Schwenk- bzw. Wippbewegung der Einheit zu der Befestigungseinrichtung ermöglicht.

Eine schwenkbare Ausbildung wenigstens eines Befestigungsadapters verhindert, dass Verspannungen bzw. Verwindungen des Flugzeugs bzw. der Sitzschienen auf die zu befestigende Einheit übertragen werden. Dies ist besonders bedeutsam, wenn es sich bei der zu befestigenden Einheit um einen Flugdatenspeicher handelt.

In einer weiteren Ausgestaltung der Erfindung kann es vorteilhaft sein, wenn wenigstens ein Befestigungsadapter einen im wesentlichen zweiteiligen Aufbau aufweist, wobei ein erster Teil des Befestigungsadapters über die Befestigungsglieder mit der Befestigungseinrichtung und ein zweiter Teil des Befestigungsadapters mit der Einheit verbindbar ist, wobei die beiden Teile des Befestigungsadapters zueinander verschiebbar sind.

Durch den zweiteiligen Aufbau eines Befestigungsadapters und die Verschiebbarkeit der beiden Teile zueinander lässt sich der Befestigungsadapter in einfacher Weise auf unterschiedliche Abstände zwischen zwei Befestigungseinrichtungen, beispielsweise zwei Sitzschienen, einstellen. Des weiteren können aus der Bewegung des Fahrzeuges resultierende Verspannungen bzw. Verwindungen sowie unterschiedliche Wärmeausdehnungen zwischen der Einheit und den Sitzschienen bzw. dem Fahrzeug kompensiert werden. Verspannungen, Verwindungen sowie eine Wärmeausdehnung führt somit zu einer ausgleichenden Bewegung beispielsweise einer gleitenden Bewegung der beiden zueinander beweglichen Teile des zweiteiligen Befestigungsadapters.

Die zu befestigende Einheit kann z.B. mittels einem unbeweglichen bzw. starren Befestigungsadapter mit einer ersten Sitzschiene verbunden werden. Alternativ dazu kann die zu befestigende Einheit jedoch auch direkt, d.h. ohne einen Befestigungsadapter, in eine erste Sitzschiene eingebracht werden. Mit der zweiten Sitzschiene wird die Einheit anschließend mittels dem zweiteiligen Befestigungsadapter verbunden. Durch eine entsprechende Verschiebung der beiden Teile des zweiteiligen Befestigungsadapters zueinander kann der Befestigungsadapter auf den Abstand zwischen den beiden Sitzschienen eingestellt werden, d.h. der Abstand zu dem starren Befestigungsadapter bzw. der ersten Sitzschiene kann vergrößert oder verkleinert werden. Da die Sitzschienen zwar oftmals einen unterschiedlichen Abstand zueinander aufweisen, diese Differenzen in der Regel jedoch nicht allzu groß sind, kann bereits durch eine relativ geringe Verschiebbarkeit der beiden Teile des zweiteiligen Befestigungsadapters eine Angleichung erfolgen. Zum Ausgleich von Verspannungen und dergleichen reicht bereits eine minimale Verschiebbarkeit bzw. Gleitfähigkeit aus.

Alternativ kann auch vorgesehen sein, dass die Verbindung zwischen der Einheit und der ersten Sitzschiene ebenfalls mittels einem Befestigungsadapter erfolgt, der einen zweiteiligen Aufbau aufweist.

Erfindungsgemäß ermöglicht der auf unterschiedliche Sitzschienenabstände einstellbare, zweiteilig aufgebaute Befestigungsadapter eine Schwenkbewegung der Einheit zu der Befestigungseinrichtung. Dies erfolgt dadurch, dass eine Gelenkverbindung vorgesehen ist, über die die beiden Teile des Befestigungsadapters miteinander verbunden sind. Es kann auch vorgesehen sein, dass der bzw. die Befestigungsadapter so zueinander verschiebbar sind, dass unterschiedliche Abstände zwischen den Befestigungseinrichtungen bzw. Sitzschienen kompensiert werden können, ohne dass eine Schwenkbewegung möglich ist. Andererseits ist es auch möglich, dass der bzw. die Befestigungsadapter eine Schwenkbewegung der Einheit zu der Befestigungseinrichtung ermöglichen, ohne dass ein zweiteiliger Aufbau realisiert wird, der eine Verschiebung der beiden Teile zueinander ermöglicht. Die konstruktiven Lösungen "Einstellbarkeit eines Befestigungsadapters auf den Sitzschienenabstand" und "Schwenk- bzw. Wippbewegung zum Ausgleich von Verspannungen" können folglich auch unabhängig voneinander realisiert werden.

Besonders vorteilhaft ist es jedoch, wenn wenigstens einer der Befestigungsadapter, mittels dem die Einheit mit der Befestigungseinrichtung verbunden ist, sowohl eine Schwenkbewegung als auch eine Veränderung des Abstands ermöglicht.

Vorteilhafte Ausgestaltungen und Weiterbildungen der Erfindung ergeben sich aus den weiteren Unteransprüchen.

Nachfolgend ist eine Ausführungsbeispiel der Erfindung prinzipmäßig dargestellt.

Es zeigt:
- Fig. 1: die erfindungsgemäße Vorrichtung mit einer zu befestigenden Einheit und zwei schienenförmigen Befestigungseinrichtungen in einer Explosionsdarstellung;
- Fig. 2: die erfindungsgemäße Vorrichtung gemäß Fig. 1 in einer Seitenansicht im montierten Zustand;
- Fig. 3: eine vergrößerte Einzeldarstellung gemäß dem Ausschnitt III der Fig. 2;
- Fig. 4: eine vergrößerte Einzeldarstellung gemäß dem Ausschnitt IV der Fig. 2;
- Fig. 5: eine vorderseitige Ansicht der erfindungsgemäßen Vorrichtung gemäß Pfeilrichtung V der Fig. 2;
- Fig. 6: eine vergrößerte Darstellung der Einzelheit VI der Fig. 5;
- Fig. 7: eine Darstellung der erfindungsgemäßen Vorrichtung von unten gemäß Pfeilrichtung VII der Fig. 2;
- Fig. 8: eine Ansicht der erfindungsgemäßen Vorrichtung von oben - ohne die zu befestigende Einheit;
- Fig. 9: eine Seitenansicht einer alternativen Ausgestaltung der erfindungsgemäßen Vorrichtung mit zwei Befestigungsadaptern, die jeweils verschiebbar ausgebildet sind;
- Fig. 10: eine Explosionsdarstellung der erfindungsgemäßen Vorrichtung gemäß der in Fig. 9 dargestellten alternativen Ausgestaltung;
- Fig. 11: eine Seitenansicht der erfindungsgemäßen Vorrichtung gemäß der in Fig. 9 dargestellten alternativen Ausgestaltung mit einer Schnittdarstellung der Befestigungsadapter;
- Fig. 12: eine vergrößerte Einzeldarstellung gemäß dem Ausschnitt XII der Fig. 11;
- Fig. 13: eine Ansicht der erfindungsgemäßen Vorrichtung gemäß der in Fig. 9 dargestellten alternativen Ausgestaltung von oben - ohne die zu befestigende Einheit, und
- Fig. 14: eine vergrößerte Einzeldarstellung gemäß dem Ausschnitt XIV der Fig. 13.

Das Ausführungsbeispiel zeigt eine Einsatzmöglichkeit der erfindungsgemäßen Vorrichtung. Dabei ist eine zu befestigende Einheit 1 als Adapter für einen nicht näher dargestellten Flugdatenspeicher ausgebildet. Die Befestigungseinrichtungen 2, an denen der Adapter 1 befestigt werden soll, sind als Befestigungsschienen bzw. als Sitzschienen 2 ausgebildet. Dabei ist vorgesehen, dass der Adapter 1 an zwei Sitzschienen 2 befestigt wird. Die Sitzschienen 2 stellen im Ausführüngsbeispiel Sitzschienen eines Luftfahrzeugs bzw. eines Flugzeugs dar, das mit weiteren Vorkehrungen zur Durchführung eines Bildfluges, beispielsweise einer digitalen Kamera, ausgerüstet ist.

Das Ausführungsbeispiel zeigt nur eines der möglichen Einsatzgebiete der erfindungsgemäßen Vorrichtung. Prinzipiell kann mit der erfindungsgemäßen Vorrichtung eine beliebige Einheit an beliebig gestalteten Befestigungseinrichtungen, vorzugsweise Befestigungsschienen, befestigt werden. Dabei kann es sich um Befestigungseinrichtungen bzw. Befestigungsschienen eines beliebigen Fahrzeugs handeln. Unter dem Begriff Fahrzeug sollen dabei sowohl Land- als auch Luft- und Wasserfahrzeuge verstanden werden. Die erfindungsgemäße Vorrichtung eignet sich in besonderer Weise zum Einsatz in Fahrzeugen, die in üblicher Weise mit Befestigungsschienen, insbesondere mit Sitzschienen, versehen sind, wie dies beispielsweise bei Bussen, Militärfahrzeugen, Lastkraftfahrzeugen und Flugzeugen der Fall ist. Die Erfindung ist nicht auf die im Ausführungsbeispiel dargestellte Ausführungsform beschränkt.

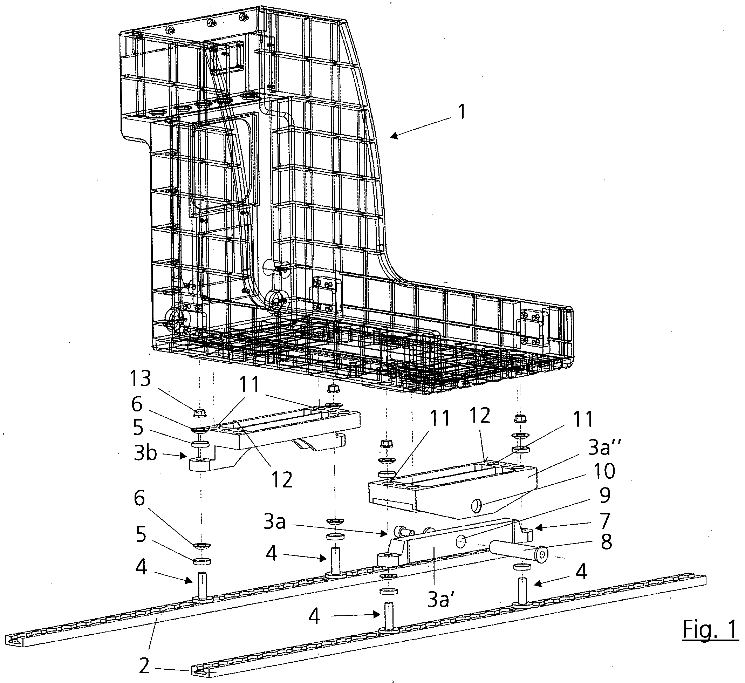

Fig. 1 zeigt den zur Aufnahme des Flugdatenspeichers vorgesehenen Adapter 1, der an zwei Sitzschienen 2 befestigt werden soll. Dabei sind zwei Befestigungsadapter 3a, 3b vorgesehen, welche einerseits mit dem zu befestigenden Adapter 1 des Flugdatenspeichers und andererseits mit den Sitzschienen 2 verbindbar sind. Zur Verbindung der Befestigungsadapter 3a, 3b mit den Sitzschienen 2 sind dabei speziell an die Sitzschienen 2 angepasste Befestigungsglieder 4 vorgesehen. Im Ausführungsbeispiel sind die Befestigungsglieder als bekannte Sitzschienenfittings 4 ausgebildet. Wie nachfolgend näher dargestellt ist, weisen die Sitzschienenfittings 4 jeweils eine Kegelpfanne 5 und eine Kugelscheibe 6 auf. Dadurch kann in bekannter Weise eine leichte Abweichung von der vorgesehenen Ausrichtung der Sitzschienenfittings 4 bzw. der Sitzschiene 2 korrigiert werden.

Im Ausführungsbeispiel sind jeweils zwei Sitzschienenfittings 4 zur Befestigung eines Befestigungsadapters 3a, 3b an einer Sitzschiene 2 vorgesehen. Wie aus Fig. 1, Fig. 2, Fig. 5, Fig. 7 und Fig. 8 ersichtlich ist, ist ein Befestigungsadapter 3a derart ausgebildet, dass eine Schwenkbewegung des Adapters 1 zu den Sitzschienen 2 möglich ist. Der die Schwenkbewegung ermöglichende Befestigungsadapter 3a weist hierzu eine Gelenkverbindung 7 auf, über die der Adapter 1 mit der zugeordneten Sitzschiene 2 verbunden ist.

Wie sich aus den Figuren ergibt, ist die Gelenkverbindung 7 durch einen Bolzen 8 und Bohrungen 9, 10 ausgebildet. Der Befestigungsadapter 3a ist dabei zweiteilig ausgebildet, wobei die beiden Teile 3a' und 3a" durch den Bolzen 8 miteinander verbunden werden. Ein erster Teil 3a' des Befestigungsadapters 3a ist über die Sitzschienenfittings 4 mit der zugeordneten Sitzschiene 2 verbunden. Der zweite Teil 3a" des Befestigungsadapters 3a ist mit dem Adapter 1 für den Flugdatenspeicher mittels einer nicht näher dargestellten Schraubverbindung verbunden.

Dadurch, dass die beiden Teile 3a' und 3a" lediglich über den Bolzen 8 miteinander verbunden sind, kann der Adapter 1 eine leichte Schwenk- bzw. Wippbewegung zu den Sitzschienen 2 bzw. einem Boden des Flugzeugs, in dem die Sitzschienen 2 angeordnet sind, durchführen. Somit wird verhindert, dass Verspannungen bzw. Verwindungen auf den Adapter 1 und somit in der Folge auch auf den Flugdatenspeicher übertragen werden.

Wie sich insbesondere aus Fig. 1 ergibt, weist das dem Adapter 1 zugewandte zweite Teil 3a" des Befestigungsadapters 3a einen wippenartigen Aufbau auf, d.h. das Teil 3a" verjüngt sich, ausgehend von der zur Aufnahme für den Bolzen 8 vorgesehenen Bohrung 10 in Richtung auf den Adapter 1. Dadurch ist die Schwenk- bzw. Wippbewegung des Adapters 1 zu den Sitzschienen 2 konstruktiv durch das zweite Teil 3a" des Befestigungsadapters 3a nicht eingeschränkt.

Wie sich aus einer Zusammenschau der Figuren 1 bis 8 ergibt, ist der Adapter 1 somit über eine Dreipunktauflage (die beiden Sitzschienenfittings 4 des Befestigungsadapters 3b und den Bolzen 8 des Befestigungsadapters 3a) mit den Sitzschienen 2 verbunden.

Wie sich aus den Figuren 1 bis 9 ergibt, sind die beiden Teile 3a' und 3a" des Befestigungsadapters 3a zueinander verschiebbar bzw. zueinander gleitfähig.

Gemäß Fig. 1 bis Fig. 8 ist vorgesehen, dass der Adapter 1 mittels einem starren Befestigungsadapter 3b und einem im wesentlichen aus zwei Teilen 3a', 3a" ausgebildeten Befestigungsadapter 3a mit den Sitzschienen 2 verbunden wird. Aufgrund der Beweglichkeit der beiden Teile 3a' und 3a" zueinander kann der Abstand zwischen den Sitzschienenfittings 4 des zweiteiligen Befestigungsadapters 3a und den Sitzschienenfittings 4 des starren Befestigungsadapters 3b variiert werden. Der zweiteilig aufgebaute Befestigungsadapter 3a ermöglicht, dass Verspannungen und Verwindungen von den Sitzschienen 2 bzw. dem Flugzeug nicht auf den Adapter 1 übertragen werden, sondern zu einer Bewegung der beiden Teile 3a', 3a" des zweiteiligen Befestigungsadapters 3a zueinander führen. Die Verspannungen und dergleichen werden somit ausgeglichen.

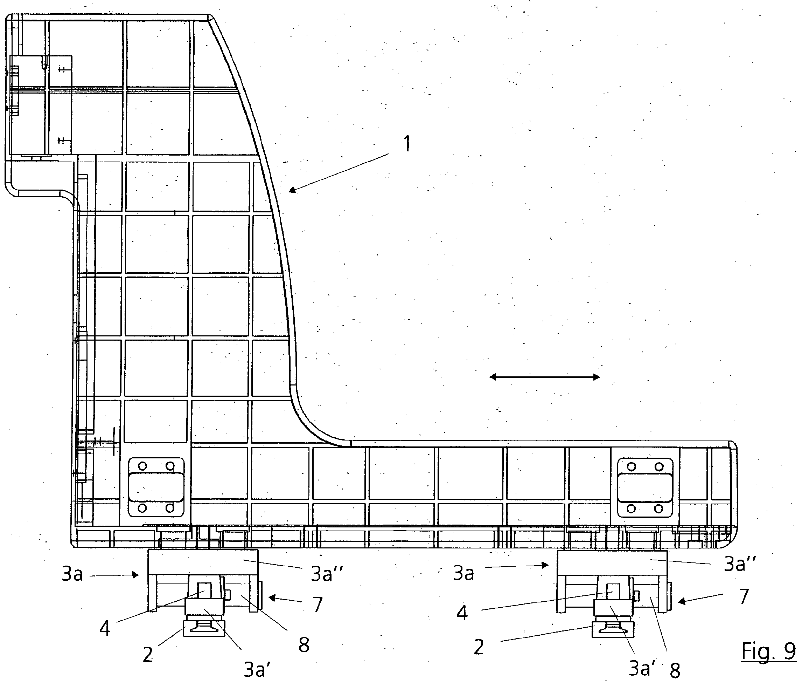

Gemäß Fig. 9 ist der Einsatz von zwei Befestigungsadaptern 3a vorgesehen. Die Befestigung des Adapters 1 kann somit auch an zwei Sitzschienen 2 erfolgen, die besonders nah beisammen bzw. besonders weit auseinander liegen. Gemäß Fig. 9 ist vorgesehen, dass einer der beiden Befestigungsadapter 3a (alternativ auch beide) mit zwei Bolzen 8 versehen ist. Ein mit zwei Bolzen 8 versehener Befestigungsadapter 3a ermöglicht zwar keine Schwenkbewegung des Adapters 1 zu den Sitzschienen 2, jedoch wird durch die Ausgestaltung mit zwei Bolzen 8 eine besonders sichere und stabile Anordnung des Adapters 1 ermöglicht. Vorzugsweise weist gemäß Fig. 9 ein Befestigungsadapter 3a zwei Bolzen 8 und ein Befestigungsadapter 3a lediglich einen Bolzen 8 (gemäß Fig. 1) auf. Daraus entsteht wiederum eine vorteilhafte Dreipunktauflage.

Wie insbesondere aus Fig. 1, Fig. 2 und Fig. 8 ersichtlich ist, weisen die Befestigungsadapter 3a, 3b zur Verbindung mit dem Adapter 1 mehrere Befestigungsbohrungen 11 auf, die eine variable Positionierung des Befestigungsadapters 3a bzw. 3b an dem Adapter 1 ermöglichen. Zur stabilen Auflage des Adapters 1 auf den Befestigungsadaptern 3a, 3b und damit eine Mehrzahl an Befestigungsbohrungen 11 realisiert werden kann, weisen die Befestigungsadapter 3a, 3b eine entsprechend große Auflagefläche 12 auf, die jeweils mit den Befestigungsbohrungen 11 versehen ist.

Wie sich aus den Figuren 1, 2 und 8 ergibt, ist die Auflagefläche 12 des Befestigungsadapters 3b im Hinblick auf die zur Durchführung der Sitzschienenfittings 4 vorgesehenen Bohrungen asymmetrisch angeordnet. Im Ausführungsbeispiel ist die Auflagefläche 12 des Befestigungsadapters 3b in Richtung auf den Befestigungsadapter 3a ausgerichtet. Um einen besonders kleinen Abstand zwischen zwei Sitzschienen 2 auszugleichen, kann dabei vorgesehen sein, dass der Befestigungsadapter 3b um 180° geschwenkt montiert wird, d.h. dass sich die Auflagefläche 12 des Befestigüngsadapters 3b in die von dem Befestigungsadapter 3a entgegengesetzte Richtung erstreckt.

Gemäß Fig. 1 ist zur Montage eines Adapters 1 zur Aufnahme eines Flugdatenspeichers vorgesehen, dass in einem ersten Schritt jeweils zwei Sitzschienenfittings 4 in der jeweils zugeordneten Sitzschienen 2 befestigt werden. Die Sitzschienenfittings 4 werden dabei mit einer Kegelpfanne 5 und einer Kugelscheibe 6 versehen. Danach wird der Befestigungsadapter 3b bzw. das erste Teil 3a' des Befestigungsadapters 3a aufgesetzt. Anschließend wird eine weitere Kegelpfanne 5, eine weitere Kugelscheibe 6 sowie eine Mutter 13 auf den jeweiligen Sitzschienenfitting 4 aufgebracht. Durch die Muttern 13 wird der entsprechend zugeordnete Befestigungsadapter 3b bzw. das erste Teil 3a' des Befestigungsadapters 3a verschraubt bzw. befestigt. Der Befestigungsadapter 3b kann nunmehr direkt mit dem Adapter 1 verschraubt werden, wozu zwei oder mehrere der Befestigungsbohrungen 11 verwendet werden. Bevor der Befestigungsadapter 3a mit dem Adapter 1 verbunden werden kann, muss noch der zweite Teil 3a" des Befestigungsadapters 3a mit dem ersten Teil 3a' des Befestigungsadapters 3a verbunden werden. Hierzu wird die Bohrung 9 des ersten Teils 3a' und die Bohrungen 10 des zweiten Teils 3a" fluchtend übereinander gebracht und der Bolzen 8 entsprechend eingebracht und fixiert. Der erste Teil 3a' ist nunmehr mit dem zweiten Teil 3a" über eine Gelenkverbindung 7 verbunden, welche eine Schwenkbewegung des Adapters 1 zu den Sitzschienen 2 ermöglicht. Die Gelenkverbindung 7 dient dabei auch als Linearführung für die Bewegung der beiden Teile 3a', 3a" zueinander. In einem letzten Arbeitsgang kann nunmehr der Befestigungsadapter 3a bzw. dessen zweites Teil 3a" über zwei oder mehrere Befestigungsbohrungen 11 mit dem Adapter 1 verschraubt werden.

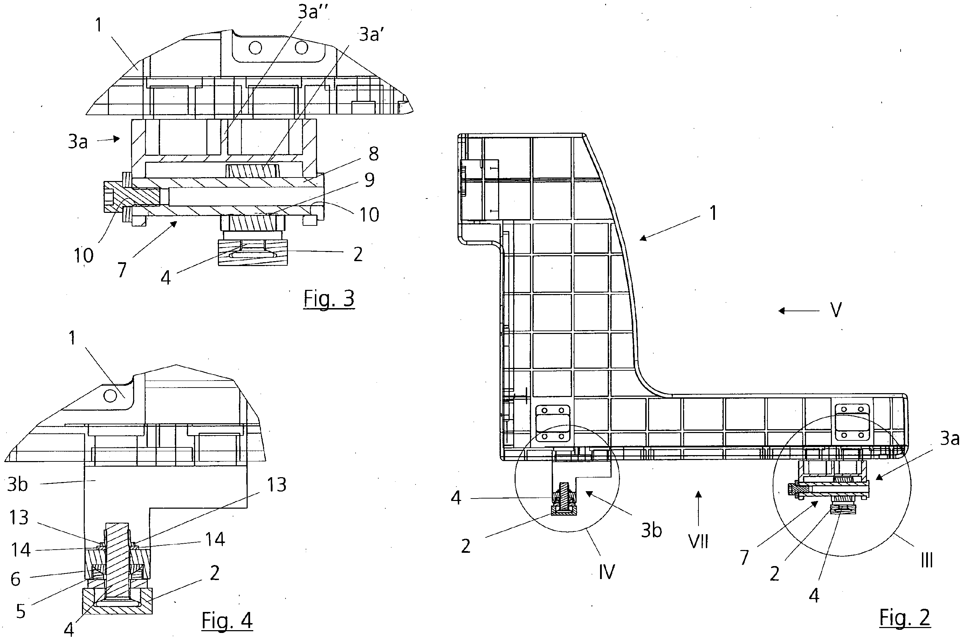

Daraus entsteht die in Fig. 2 dargestellte Anordnung.

Fig. 4 zeigt im Detail den Befestigungsadapter 3b mit einer Darstellung eines Sitzschienenfittings 4. Aufgrund der Anordnung einer Kegelpfanne 5 und einer Kugelscheibe 6 kann eine leichte Abweichung des Sitzschienenfittings 4 von der vorgesehenen Ausrichtung ausgeglichen werden. Der Sitzschienenfitting 4 ist im dargestellten Ausführungsbeispiel mit einem Gewinde zum Aufschrauben der Mutter 13 versehen. Im Unterschied zu der in Fig. 1 dargestellten Ausführungsform ist gemäß Fig. 2 bzw. Fig. 3 zwischen der Mutter 13 und der entsprechenden Durchgangsbohrung des Befestigungsadapters 3b für den Sitzschienenfitting 4 lediglich eine Unterlagscheibe 14 anstelle einer weiteren Kegelpfanne 5 bzw. einer weiteren Kugelscheibe 6 vorgesehen.

Fig. 3 zeigt eine vergrößerte Darstellung des Befestigungsadapters 3a. Die Möglichkeit, das erste Teil 3a' des Befestigungsadapters 3a zu dem zweiten Teil 3a" zu verschieben und somit unterschiedliche Abstände zwischen zwei Sitzschienen 2 zu berücksichtigen bzw. eine Gleitbewegung zum Ausgleich von Verspannungen durchzuführen, ergibt sich dabei deutlich. Die Verschiebung der beiden Teile 3a' und 3a" zueinander erfolgt dabei entlang der Achse des Bolzens 8.

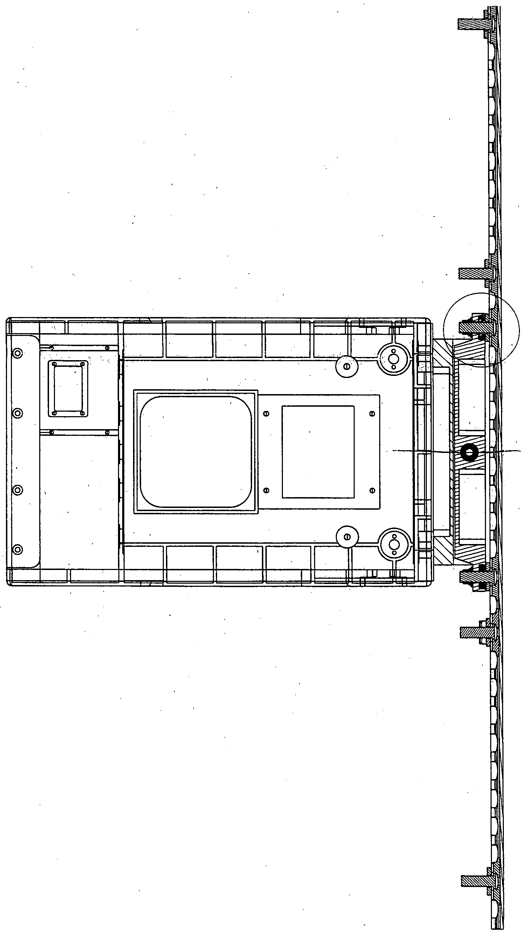

Fig. 5 zeigt eine Ansicht von vorne auf den Befestigungsadapter 3a mit einer Draufsicht auf die Gelenkverbindung 7 bzw. den Bolzen 8.

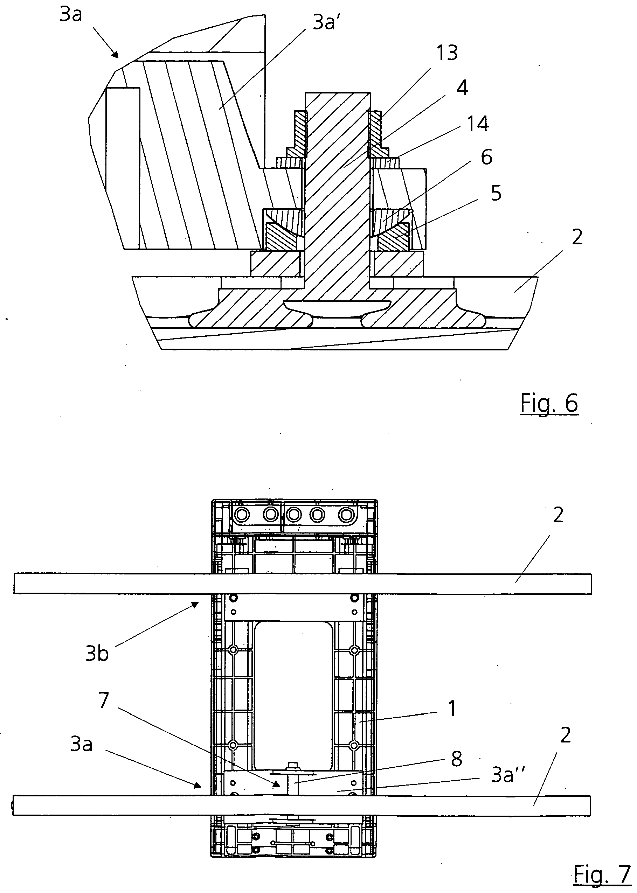

Fig. 6 zeigt den Sitzschienenfitting 4 und den daran angeordneten ersten Teil 3a' des Befestigungsadapters 3a aus einer zu Fig. 4 um 90° versetzten Darstellung.

Fig. 7 zeigt eine Ansicht der beiden Befestigungsadapter 3a, 3b von unten, aus der deutlich die Schwenkbarkeit des Befestigungsadapters 3a sowie die Möglichkeit, die beiden Teile 3a' und 3a" zueinander zu verschieben, ersichtlich ist.

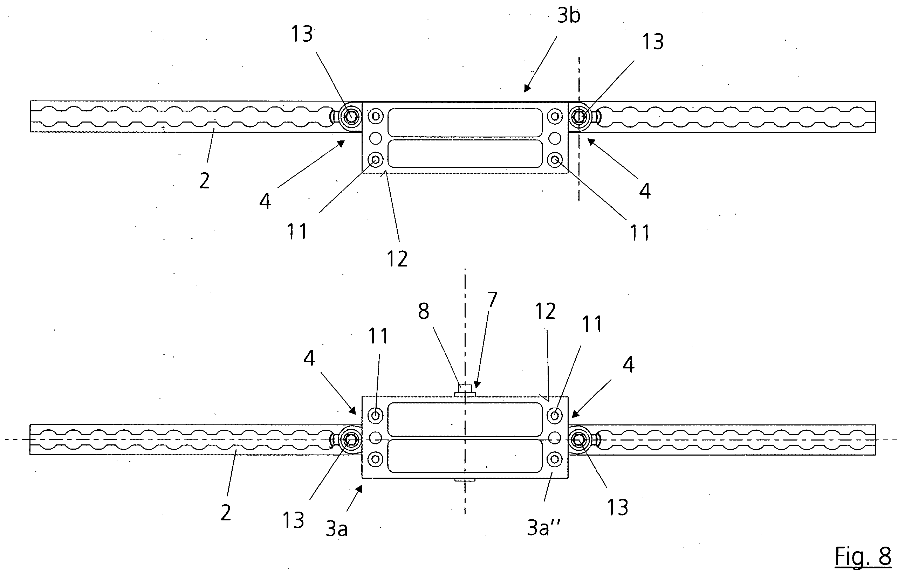

Fig. 8 zeigt eine Draufsicht auf die beiden Befestigungsadapter 3a, 3b in einem Zustand, in dem diese jeweils an einer Sitzschiene 2 befestigt sind.

Fig. 9 zeigt eine zu den Figuren 1 bis 8 alternative Ausführungsform, bei der der Adapter 1 zur Aufnahme des Flugdatenspeichers mittels zweier Befestigungsadapter 3a an den Sitzschienen 2 befestigt ist.

Die Befestigungsadapter 3a, 3b sind im Ausführungsbeispiel jeweils am Ende des Adapters 1 angeordnet. Die Befestigungsadapter 3a, 3b bzw. deren Auflageflächen 12 erstrecken sich dabei über die gesamte Breite des Adapters 1 zur Aufnahme eines Flugdatenspeichers. Der Befestigungsadapter 3b weist im Querschnitt betrachtet ein U-förmiges Profil auf, wobei der Befestigungsadapter 3b im Bereich seiner U-förmigen Enden mit einer Durchgangsbohrung versehen ist, die zum Verschrauben mit der zugehörigen Sitzschiene 2 dient.

Alternativ zu dem Bolzen 8 kann der Befestigungsadapter 3a auch mit einer beliebigen anderen Längsführung versehen sein, die ein Gleiten des Adapters 1 relativ zu dem Befestigungsadapter 3a bzw. dessen mit der Sitzschiene 2 verbundenen ersten Teil 3a' ermöglicht. Die hierfür notwendige Linearführung kann beispielsweise als Schiene, Nut-Feder-Verbindung oder dergleichen ausgebildet sein. Wesentlich ist dabei lediglich, dass der Adapter 1 nicht fest bzw. starr mit den beiden Sitzschienen 2 verbunden, sondern zu wenigstens einer Sitzschiene 2 beweglich ist, sodass Verspannungen ausgeglichen werden können.

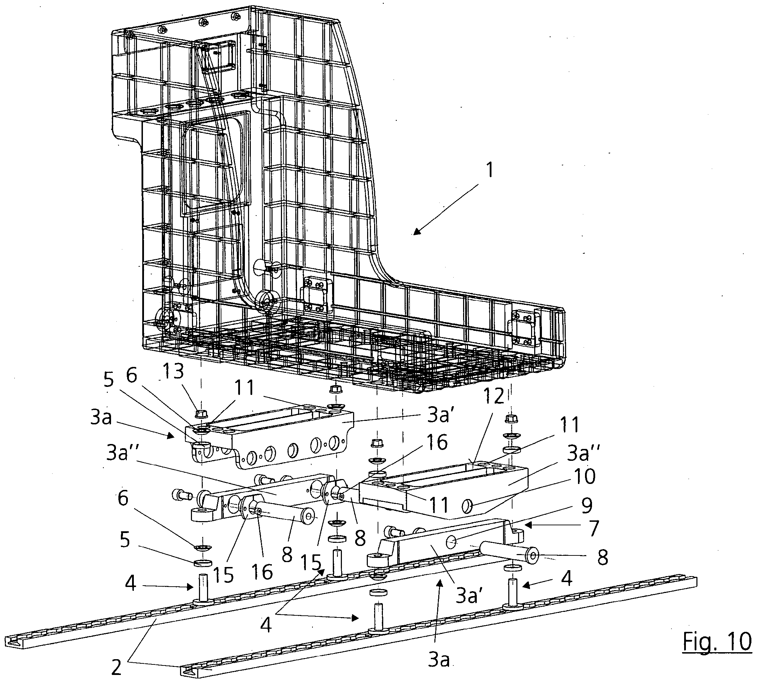

Fig. 10 zeigt eine Explosionsdarstellung der in Fig. 9 dargestellten alternativen Ausführungsform. Die in Fig. 10 dargestellte Explosionsdarstellung entspricht weitgehend der in Fig. 1 dargestellten Explosionsdarstellung mit Ausnahme der alternativen Ausführungsform eines Befestigungsadapters, wobei der in Fig. 1 dargestellte Befestigungsadapter 3b durch einen Befestigungsadapter 3a ersetzt ist, welcher zwei Bolzen 8 aufweist. Der in Fig. 10 mit zwei Bolzen 8 dargestellte Befestigungsadapter 3a weist ein erstes Teil 3a' zur Befestigung an dem Adapter 1 und ein zweites Teil 3a" zur Verbindung mit der Sitzschiene 2 auf.

Die gemäß den Figuren 9 bis 14 dargestellte alternative erfindungsgemäße Ausgestaltung ermöglicht es, den Adapter 1 für den Flugdatenspeicher auch nach dem Befestigen an den Sitzschienen 2 relativ zu den Sitzschienen zu verschieben. Zur Fixierung in der gewünschten Position weist der mit den zwei Bolzen 8 versehene Befestigungsadapter 3a zwei Konushülsen 15 auf, die jeweils über zwei Fixierschrauben 16 verkeilt werden können. Nach dem Verkeilen der Konushülsen 15 durch die Fixierschrauben 16 ist der Adapter 1 in der gewünschten Position arretiert.

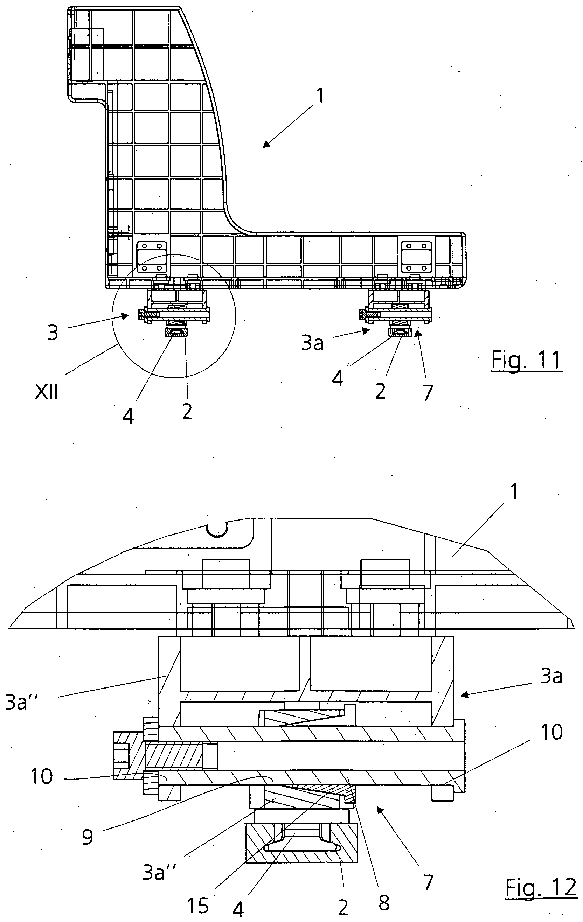

Fig. 11 und Fig. 12 zeigen einen Querschnitt durch den mit zwei Bolzen 8 versehenen Befestigungsadapters 3a. Aus Fig. 11 und Fig. 12 ergibt sich dabei die Funktionsweise der Konushülsen 15 zum Arretieren der Bolzen 8 zu dem zweiten Teil 3a", wodurch der Adapter 1 zu den Sitzschienen 2 nicht mehr beweglich ist. Die weiteren in Fig. 11 dargestellten Teile entsprechen im wesentlichen den bereits hinsichtlich Fig. 2 und Fig. 3 beschriebenen Teilen.

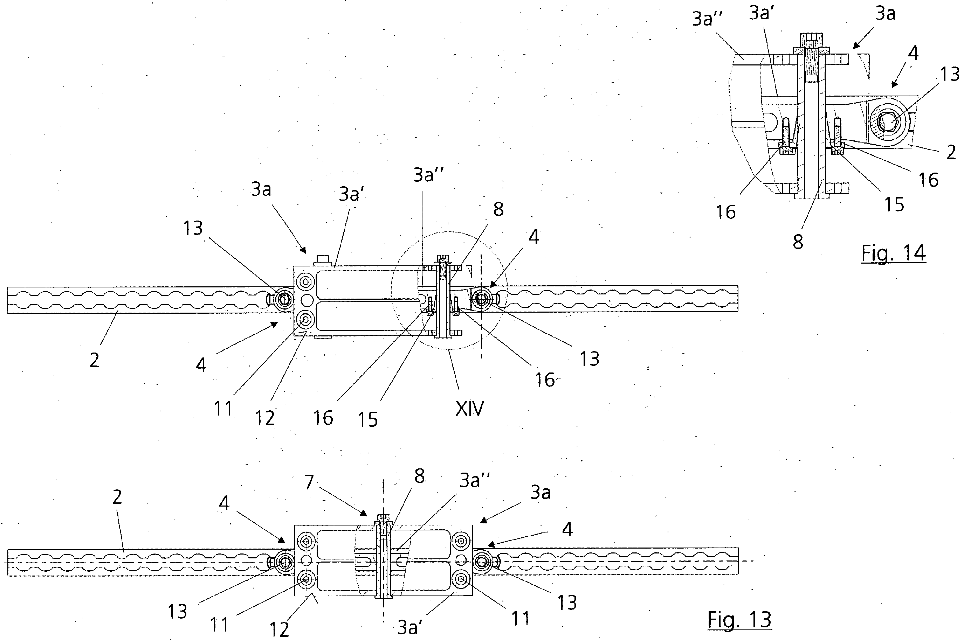

Fig. 13 zeigt eine Draufsicht auf die beiden Befestigungsadapter 3a gemäß den Figuren 9 bis 12 in einem Zustand, in dem diese jeweils an einer Sitzschiene 2 befestigt sind. Eine derartige Darstellung wurde, mit Ausnahme des nunmehr alternativen eingesetzten Befestigungsadapters 3a, bereits hinsichtlich Fig. 8 in Bezug auf die Ausführungsform der erfindungsgemäßen Vorrichtung anhand der Figuren 1 bis 8 beschreiben. Fig. 14 zeigt dabei eine vergrößerte Schnittdarstellung des Befestigungsadapters 3a im Bereich eines seiner Bolzen 8. Aus Fig. 13 und Fig. 14 ergibt sich eine Darstellung einer Konushülse 15 die durch Einschrauben der zwei Fixierschrauben 16 zu dem Bolzen 8 verkeilt werden kann.

## Patentansprüche

1. Vorrichtung zur Befestigung einer Einheit (1) an wenigstens eine erste Luftfahrzeugsitzschiene (2), welche eine erste Längsachse aufweist, **gekennzeichnet durch** folgende Merkmale:
- einen ersten Befestigungsadapter (3a), der ein erstes Adapterteil (3a') und ein zweites Adapterteil (3a") aufweist;
- das erste Adapterteil (3a') ist mit der ersten Luftfahrzeugsitzschiene (2) verbindbar;
- das zweite Adapterteil (3a") ist mit der Einheit (1) verbindbar;
- der erste Befestigungsadapter (3a) weist eine erste Gelenkverbindung (7) auf, wodurch das erste Adapterteil (3a') und das zweite Adapterteil (3a") miteinander verbunden sind;
- die erste Gelenkverbindung (7) ist derart ausgelegt, dass die Einheit (1) schwenkbar mit Bezug auf die erste Luftfahrzeugsitzschiene (2) ist, und zwar durch eine schwenkbare Verbindung des ersten Adapterteils (3a') und des zweiten Adapterteils (3a") des ersten Befestigungsadapters (3a) relativ zueinander, um nicht mehr als eine erste Drehachse (8), die in eine Richtung quer zu der ersten Längsachse der ersten Luftfahrzeugsitzschiene (2) verläuft; und
- die erste Gelenkverbindung (7) ist weiterhin derart ausgelegt, dass die Einheit (1) entsprechend unterschiedlicher Abstände zwischen zwei Luftfahrzeugsitzschienen (2), die die erste Luftfahrzeugsitzschiene (2) aufweisen, befestigbar ist, wobei das erste Adapterteil (3a') und das zweite Adapterteil (3a") des ersten Befestigungsadapters (3a) relativ zueinander in axialer Richtung der ersten Drehachse (8) bewegbar sind.

2. Vorrichtung nach Anspruch 1, **gekennzeichnet durch**
einen zweiten Befestigungsadapter (3a, 3b), der mit der Einheit (1) in Bezug auf eine zweite Luftfahrzeugsitzschiene (2), die eine zweite Längsachse aufweist, verbunden ist.

3. Vorrichtung nach Anspruch 2, wobei der zweite Befestigungsadapter (3a, 3b) folgende Merkmale aufweist:
- ein erstes Adapterteil (3a') und ein zweites Adapterteil (3a");
- das erste Adapterteil (3a') des zweiten Befestigungsadapters (3a) ist mit der zweiten Luftfahrzeugsitzschiene (2) verbindbar;
- das zweite Adapterteil (3a") des zweiten Befestigungsadapters (3a) ist mit der Einheit (1) verbindbar;
- der zweite Befestigungsadapter (3a) weist eine zweite Gelenkverbindung (7) auf, durch die das erste Adapterteil (3a') und das zweite Adapterteil (3a") des zweiten Befestigungsadapters (3a) miteinander verbunden sind;
- die zweite Gelenkverbindung (7) ist derart ausgelegt, dass die Einheit (1) schwenkbar mit Bezug auf die zweite Luftfahrzeugsitzschiene (2) ist, und zwar durch eine schwenkbare Verbindung des ersten Adapterteils (3a') und des zweiten Adapterteils (3a") des zweiten Befestigungsadapters (3a) relativ zueinander, um eine zweite Drehachse (8), die quer zu der zweiten Längsachse der zweiten Luftfahrzeugsitzschiene (2) orientiert ist, wobei die zweite Gelenkverbindung (7) derart ausgelegt ist, dass das erste Adapterteil (3a') und das zweite Adapterteil (3a") des zweiten Befestigungsadapters (3a) relativ zueinander in einer axialen Richtung zu der zweiten Drehachse (8) bewegbar sind.

4. Vorrichtung nach Anspruch 1, 2 oder 3,
**dadurch gekennzeichnet, dass**
die erste Gelenkverbindung (7) und/oder die zweite Gelenkverbindung (7) durch einen Bolzen (8) und Bohrungen (9,10) in den beiden Adapterteilen (3a',3a") des ersten und/oder zweiten Befestigungsadapters (3a) ausgebildet ist.

5. Vorrichtung nach Anspruch 2,
**dadurch gekennzeichnet, dass**
der zweite Befestigungsadapter (3b) im Wesentlichen starr ausgebildet ist, während der erste Befestigungsadapter (3a) eine Schwenkbewegung zum Ausgleich von Verspannungen und/oder Verwindungen ermöglicht.

6. Vorrichtung nach einem der Ansprüche 1 bis 4,
**dadurch gekennzeichnet, dass**
der erste und/oder der zweite Befestigungsadapter (3a, 3b) zur Verbindung mit der Einheit (1) mehrere Befestigungsbohrungen (11) aufweist, die eine variable Positionierung des ersten und/oder zweiten Befestigungsadapters (3a, 3b) an der Einheit (1) ermöglichen.

7. Vorrichtung nach einem der Ansprüche 1 bis 6,
**dadurch gekennzeichnet, dass**
der erste und/oder der zweite Befestigungsadapter (3a, 3b) mittels Sitzschienenfittings (4), welche mit dem ersten Adapterteil (3a') verbunden sind, mit der Luftfahrzeugsitzschiene (2) verbunden ist.

8. Vorrichtung nach Anspruch 7,
**dadurch gekennzeichnet, dass**
die Sitzschienenfittings (4) jeweils eine Kegelpfanne (5) und eine Kugelscheibe (6) aufweisen.

9. Vorrichtung nach einem der Ansprüche 1 bis 8,
**dadurch gekennzeichnet, dass**
die Einheit als Adapter (1) für einen Flugdatenspeicher ausgebildet ist.

## Claims

1. Apparatus for the attachment of a unit (1) on at least a first aircraft seat rail (2), which comprises a first longitudinal axis,
**characterized by**
the following features:
- a first attachment adapter (3a) having a first adapter part (3a') and a second adapter part (3a");
- the first adapter part (3a') is connectable to the first aircraft seat rail (2);
- the second adapter part (3a") is connectable to the unit (1);
- the first attachment adapter (3a) has a first articulated joint (7) by means of which the first adapter part (3a') and the second adapter part (3a") are connected to each other;
- the first articulated joint (7) is designed such that the unit (1) is pivotable in relation to the first aircraft seat rail (2) by means of a pivotable connection of the first adapter part (3a') and the second adapter part (3a") of the first attachment adapter (3a) relative to each other around not more than a first rotation axis (8) running in a direction transverse to the first longitudinal axis of the first aircraft seat rail (2); and
- the first articulated joint (7) is further designed such that the unit (1) is attachable according to different distances between two aircraft seat rails (2) comprising the first aircraft seat rail (2), the first adapter part (3a') and the second adapter part (3a") of the first attachment adapter (3a) being movable relative to each other in the axial direction of the first rotation axis (8).

2. Apparatus according to claim 1,
**characterized by**
a second attachment adapter (3a,3b) being connected to the unit (1) in relation to a second aircraft seat rail (2) having a second longitudinal axis.

3. Apparatus according to claim 2, the second attachment adapter (3a,3b) having the following features:
- a first adapter part (3a') and a second adapter part (3a");
- the first adapter part (3a') of the second attachment adapter (3a) is connectable to the second aircraft seat rail (2);
- the second adapter part (3a") of the second attachment adapter (3a) is connectable to the unit (1);
- the second attachment adapter (3a) has a second articulated joint (7) by means of which the first adapter part (3a') and the second adapter part (3a") of the second attachment adapter (3a) are connected to each other;
- the second articulated joint (7) is designed such that the unit (1) is pivotable with respect to the second aircraft seat rail (2) by means of a pivotable connection of the first adapter part (3a') and the second adapter part (3a") of the second attachment adapter (3a) relative to each other around a second rotation axis (8) being oriented transverse to the second longitudinal axis of the second aircraft seat rail (2), the second articulated joint (7) being designed such that the first adapter part (3a') and the second adapter part (3a") of the second attachment adapter (3a) are movable relative to each other in an axial direction to the second rotation axis (8).

4. Apparatus according to any one of claims 1, 2 or 3,
**characterized in that**
the first articulated joint (7) and/or the second articulated joint (7) is formed by a bolt (8) and holes (9,10) in both adapter parts (3a',3a") of the first and/or second attachment adapter (3a).

5. Apparatus according to claim 2,
**characterized in that**
the second attachment adapter (3b) is essentially rigid, while the first attachment adapter (3a) allows a pivoting movement in order to compensate for stressing and/or twisting.

6. Apparatus according to any one of claims 1 to 4,
charaterized in that
the first and/or second attachment adapter (3a,3b) comprises a plurality of attachment holes (11) for connection to the unit (1) which allow variable positioning of the attachment adapters (3a,3b) on the unit (1).

7. Apparatus according to any one of claims 1 to 6,
**characterized in that**
the first and/or the second attachment adapter (3a,3b) is connected to the aircraft seat rail (2) by means of seat rail fittings (4) which are connected to the first adapter part (3a').

8. Apparatus according to claim 7,
**characterized in that**
the seat rail fittings (4) each have a conical cap (5) and a spherical washer (6).

9. Apparatus according to any one of claims 1 to 8,
**characterized in that**
the unit (1) is formed as an adapter for a flight data recorder.

## Revendications

1. Dispositif de fixation d'une unité (1) à au moins un premier rail de siège d'un aéronef (2), qui comporte un premier axe longitudinal,
**caractérisé par**
les caractéristiques suivantes :
- un premier adaptateur de fixation (3a), comportant une première pièce d'adaptation (3a') et une deuxième pièce d'adaptation (3a") ;
- la première pièce d'adaptation (3a') est agencée pour être mise en contact avec le premier rail de siège d'un aéronef (2) ;
- la deuxième pièce d'adaptation (3a") est agencée pour être mise en contact avec l'unité (1) ;
- le premier adaptateur de fixation (3a) comporte une première liaison articulée (7) au moyen duquel la première pièce d'adaptation (3a') et la deuxième pièce d'adaptation (3a") sont couplées entre elles;
- la première liaison articulée (7) est conçue de telle manière que l'unité (1) est pivotante par rapport au premier rail de siège d'un aéronef (2), et d'ailleurs par une liaison pivotante, l'une par rapport à l'autre, de la première pièce d'adaptation (3a') et de la deuxième pièce d'adaptation (3a") du premier adaptateur de fixation (3a), et plus comme un premier axe de rotation (8), qui s'étend dans une direction transversale par rapport au premier axe longitudinal du premier rail de siège d'un aéronef (2) ; et
- la première liaison articulée (7) est en outre agencée pour que l'unité (1) puisse être fixée en laissant des espacements distincts entre deux rails de siège d'un aéronef (2), tel que le présente le premier rail de siège d'un aéronef (2), dans lequel la première pièce d'adaptation (3a') et la deuxième pièce d'adaptation (3a") du premier adaptateur de fixation (3a) sont mobiles relativement entre eux dans la direction axiale du premier axe de rotation (8).

2. Dispositif selon la revendication 1,
**caractérisé par**
un deuxième adaptateur de fixation (3a, 3b) en liaison avec l'unité (1) par rapport à un deuxième rail de siège d'un aéronef (2), comportant un deuxième axe longitudinal.

3. Dispositif selon la revendication 2, dans lequel le deuxième adaptateur de fixation (3a, 3b) présente les caractéristiques suivantes :
- une première pièce d'adaptation (3a') et une deuxième pièce d'adaptation (3a") ;
- la première pièce d'adaptation (3a') du deuxième adaptateur de fixation (3a) est agencée pour être couplée avec le deuxième rail de siège d'un aéronef (2) ;
- la deuxième pièce d'adaptation (3a") du deuxième adaptateur de fixation (3a) est agencée pour être couplée avec l'unité (1) ;
- le deuxième adaptateur de fixation (3a) comporte une deuxième liaison articulée (7), au moyen de laquelle la première pièce d'adaptation (3a') et la deuxième pièce d'adaptation (3a") du deuxième adaptateur de fixation (3a) sont couplées entre elles ;
- la deuxième liaison articulée (7) est conçue de telle manière que l'unité (1) est pivotante par rapport au deuxième rail de siège d'un aéronef (2), et d'ailleurs par une liaison pivotante de la première pièce d'adaptation (3a') et de la deuxième pièce d'adaptation (3a") du deuxième adaptateur de fixation (3a), l'une par rapport à l'autre, autour d'un deuxième axe de rotation (8), qui s'étend dans une direction transversale par rapport au deuxième axe longitudinal du deuxième rail de siège d'un aéronef (2) ; et dans lequel la deuxième liaison articulée (7) est agencée pour que la première pièce d'adaptation (3a') et la deuxième pièce d'adaptation (3a") du deuxième adaptateur de fixation (3a) sont mobiles relativement entre elles dans une direction axiale du deuxième axe de rotation (8).

4. Dispositif selon les revendications 1, 2 ou 3,
**caractérisé en ce que**,
la première liaison articulée (7) et/ou la deuxième liaison articulée (7) sont réalisées sous la forme d'un boulon (8) et d'alésages (9,10) ménagés dans les deux pièces d'adaptation (3a', 3a") du premier et/ou du deuxième adaptateur de fixation (3a).

5. Dispositif selon la revendication 2,
**caractérisé en ce que**
le deuxième adaptateur de fixation (3b) est en réalité construit de manière rigide tandis que le premier adaptateur de fixation (3a) est agencé pour permettre un pivotement pour compenser une tension et/ou une torsion.

6. Dispositif selon l'une des revendications 1 à 4,
**caractérisé en ce que**,
le premier et/ou le deuxième adaptateur de fixation (3a, 3b) comportent plusieurs alésages (11) pour la liaison avec l'unité (1) permettant un positionnement variable du premier et/ou du deuxième adaptateur de fixation (3a, 3b) par rapport à l'unité (1).

7. Dispositif selon l'une des revendications 1 à 6,
**caractérisé en ce que**,
le premier et/ou le deuxième adaptateur de fixation (3a, 3b) sont liés à l'aéronef (2) via des éléments de fixation de rails de sièges (4) qui sont liés à la première pièce d'adaptation (3a').

8. Dispositif selon la revendication 7,
**caractérisé en ce que**,
les éléments de fixation de rails de sièges (4) comportent respectivement une butée conique (5) et une coupelle sphérique (6).

9. Dispositif selon l'une des revendications 1 à 8,
**caractérisé en ce que**,
l'unité consiste en un adaptateur (1) pour un enregistreur de données de vol.
